# EUROPÄISCHE PATENTSCHRIFT

(11) **EP 2 932 598 B1**
(45) Veröffentlichungstag und Bekanntmachung des Hinweises auf die Patenterteilung: **09.09.2020**
(21) Anmeldenummer: 13821182.6
(22) Anmeldetag: 09.12.2013
(51) Int. Cl.: H03K 17/10, H03K 17/0412, H03K 17/74, H03K 17/06, H03K 17/687

(54) **SCHALTKOMPONENTE, INSBESONDERE HAUSGERÄTESCHALTKOMPONENTE**
SWITCHING COMPONENT, IN PARTICULAR DOMESTIC-APPLIANCE SWITCHING COMPONENT
COMPOSANT DE COMMUTATION, EN PARTICULIER COMPOSANT DE COMMUTATION POUR UN APPAREIL MÉNAGER

(30) Priorität: 14.12.2012 ES 201231939
(43) Veröffentlichungstag der Anmeldung: 21.10.2015
(73) Patentinhaber: BSH Hausgeräte GmbH, 81739 München (DE)
(72) Erfinder: HERNANDEZ BLASCO, Pablo Jesus, E-50410 Cuarte de Huerva (Zaragoza) (ES); LLORENTE GIL, Sergio, E-50009 Zaragoza (ES); LUCIA GIL, Oscar, E-50006 Zaragoza (ES); MEDIANO HEREDIA, Arturo, E-50012 Zaragoza (ES); PALACIOS TOMAS, Daniel, E-50008 Zaragoza (ES); SARNAGO ANDIA, Hector, E-42110 Olvega (Soria) (ES)
(86) Internationale Anmeldenummer: PCT/IB2013/060745
(87) Internationale Veröffentlichungsnummer: WO 2014/091389

(56) Entgegenhaltungen:
- EP-A2- 0 453 376
- WO-A1-2009/056452

## Beschreibung

Die Erfindung geht aus von einer Induktionskochfeldvorrichtung nach Anspruch 1.

Es sind Schaltkomponenten, die von einer Reihenschaltung von MOSFETs gebildet sind, und einen Treiberschaltkreis aufweisen, bekannt. Die bekannten Treiberschaltkreise weisen jeweils einen Widerstand oder eine Zener-Diode auf, der bzw. die zwischen Steuerkontakten des jeweiligen MOSFETs geschaltet ist.

Die EP 0 453 376 A2 zeigt eine solche Anordnung nach dem Stand der Technik.

Die Aufgabe der Erfindung besteht insbesondere darin, eine gattungsgemäße Vorrichtung mit verbesserten Eigenschaften hinsichtlich eines schnellen Ausschaltverhaltens und einer preiswerten Ausgestaltung bereitzustellen. Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.

Der Rahmen der Erfindung wird daher durch den Schutzumfang der Ansprüche definiert. Der Gegenstand jeglichen Bezugs auf "Ausführungsformen", "Beispiele" oder "Aspekte" der Erfindung in der Beschreibung, welcher nicht unter den Schutzumfang der Ansprüche fällt, sollte lediglich als Illustration oder Beispiel zum besseren Verständnis der Erfindung interpretiert werden.

Die Erfindung beinhaltet eine Schaltkomponente, insbesondere eine Hausgeräteschaltkomponente, die eine Reihenschaltung von zumindest zwei, vorteilhaft zumindest drei, vorzugsweise zumindest vier, insbesondere zumindest acht, weiterhin denkbar zumindest zwölf, Feldeffekttransistoren, und diesen zugeordnete Treiberschaltkreise aufweist.

Es wird vorgeschlagen, dass jeder Treiberschaltkreis zumindest ein Schaltelement aufweist, das in zumindest einem Betriebszustand zwei Steuerkontakte des Feldeffekttransistors kurzschließt. Insbesondere weist die Schaltkomponente eine Anzahl an Treiberschaltkreisen auf, die zumindest im Wesentlichen, insbesondere zu mindestens 50 %, insbesondere zu mindestens 80 %, vorteilhaft bis auf eins, vorzugsweise exakt, einer Anzahl der in Reihe geschalteten Feldeffekttransistoren entspricht, wobei vorteilhaft jeder der Treiberschaltkreise alleinig einem einzelnen der Feldeffekttransistoren zugeordnet ist. Unter einer "Schaltkomponente" soll insbesondere eine elektronische Komponente verstanden werden, die zwei Steuerkontakte und zwei Leistungskontakte aufweist, wobei sie dazu vorgesehen ist, in Abhängigkeit von einem Ansteuersignal zwischen den zwei Steuerkontakten, eine Leitfähigkeit zwischen den zwei Leistungskontakten einzustellen. Insbesondere sind einer der Steuerkontakte und einer der Leistungskontakte zumindest leitend miteinander verbunden, vorzugsweise kurzgeschlossen, und bilden insbesondere einen einzelnen technisch kontaktierbaren Kontakt. Alternativ ist es denkbar, dass die Steuerkontakte und die Leistungskontakte separat kontaktierbar sind. Insbesondere ist die Schaltkomponente dazu vorgesehen, in zumindest einem ersten Betriebszustand, eine Sperrspannung von zumindest 300 V, insbesondere zumindest 450 V, vorteilhaft zumindest 600 V, über den Leistungskontakten stabil zu tragen. Insbesondere ist die Schaltkomponente dazu vorgesehen, in zumindest einem zweiten Betriebszustand, einen Leistungsstrom von zumindest 1 A, insbesondere zumindest 3 A vorteilhaft zumindest 10 A, vorzugsweise zumindest 15 A, über die Leistungskontakte, vorzugsweise stabil, zu tragen. Vorteilhaft weist der Feldeffekttransistor zwei Leistungskontakte und zwei Steuerkontakte auf, wobei er dazu vorgesehen ist, eine Leitfähigkeit zwischen den Leistungskontakten in Abhängigkeit von einer Ansteuerspannung, die zwischen den Steuerkontakten anliegt, einzustellen. Vorteilhaft sind einer der Steuerkontakte und einer der Leistungskontakte des Feldeffekttransistors intern zumindest leitfähig verbunden, insbesondere kurzgeschlossen, alternativ separat kontaktierbar. Insbesondere weisen die Feldeffekttransistoren Spannungsfestigkeiten auf, so dass eine Summe der Spannungsfestigkeiten der in Reihe geschalteten Feldeffekttransistoren der Sperrspannung der Schaltkomponente entspricht. Unter einer Reihenschaltung von Feldeffekttransistoren soll insbesondere eine Reihenschaltung entlang der Leistungskontakte der Feldeffekttransistoren verstanden werden. Insbesondere weist die Schaltkomponente zwei Feldeffekttransistoren auf, die jeweils einen Leistungskontakt aufweisen, der einen Leistungskontakt der Schaltkomponente bildet. Vorzugsweise sind, insbesondere aufgrund der besseren Ladungsträgerbeweglichkeit, Elektronen die Majoritätsladungsträger der in Reihe geschalteten Feldeffekttransistoren. Vorteilhaft sind die in Reihe geschalteten Feldeffekttransitoren vom normalsperrenden Typ. Vorzugsweise sind die in Reihe geschalteten Feldeffekttransistoren vom gleichen Aktivierungstyp. Vorzugsweise ist die Schaltkomponente vom normalsperrenden Typ. Insbesondere ist es denkbar, dass die Schaltkomponente von unterschiedlichem Aktivierungstyp wie die in Reihe geschalteten Transistoren ist. Unter einem "normalsperrenden Typ" soll insbesondere verstanden werden, dass der Feldeffekttransistor und/oder die Schaltkomponente in einem Fall, in dem kein oder ein vernachlässigbares elektrisches Signal, insbesondere keine oder ein vernachlässigbare Spannung, anliegt, eine Verbindung zwischen ihren Leistungskontakten trennen. Unter einem "Treiberschaltkreis" soll insbesondere eine Elektronikbaugruppe verstanden werden, die zwischen Steuerkontakten unterschiedlicher Feldeffekttransistoren angeordnet ist. Insbesondere ist der Treiberschaltkreis dazu vorgesehen, ein Einschalten und/oder ein Ausschalten des zugeordneten Feldeffekttransistors in Abhängigkeit von einem Eingangssignal zu bewirken. Insbesondere weist der Treiberschaltkreis zumindest zwei Kontakte auf, die mit unterschiedlichen Steuerkontakten des zugeordneten Feldeffekttransistors verbunden sind. Unter einem "Schaltelement" soll insbesondere ein elektrisches Bauteil verstanden werden, dass zumindest zwei Steuerkontakte und zumindest zwei Leistungskontakte aufweist, wobei vorteilhaft einer der Steuerkontakte und einer der Leistungskontakte intern zumindest leitend miteinander verbunden, vorzugsweise kurzgeschlossen, sind und wobei das Schaltelement dazu vorgesehen ist, eine Leitfähigkeit zwischen den Leistungskontakten in Abhängigkeit von einem elektrischen Signal zwischen den Steuerkontakten einzustellen. Vorzugsweise weist das Schaltelement, wenn dieses leitend ist, zwischen den Leistungskontakten einen Spannungsabfall von betragsmäßig weniger als 0,5 V, insbesondere weniger als 0,2 V, vorzugsweise weniger als 0,05 V, auf. Insbesondere ist das Schaltelement dazu vorgesehen, die Steuerkontakte des Feldeffekttransistors über die Leistungskontakte des Schaltelements zu verbinden, wobei insbesondere die Leistungskontakte des Schaltelements jeweils mit einem Steuerkontakt des Feldeffekttransistors, vorzugsweise unmittelbar, verbunden sind. Insbesondere ist das Schaltelement als Transistor, vorteilhaft als Feldeffekttransistor, vorzugsweise als MOSFET, ausgebildet. Es sind andere, dem Fachmann bekannte Schaltelemente, insbesondere JFET, MISFET, CNTFET und HEMT, denkbar. Vorzugsweise sind Majoritätsladungsträger der in Reihe geschalteten Feldeffekttransistoren und des Schaltelements des Treiberschaltkreises unterschiedlich. Unter "vorgesehen" soll insbesondere speziell programmiert, ausgelegt und/oder ausgestattet verstanden werden.

Durch die erfindungsgemäße Ausgestaltung kann insbesondere ein schnelles Ausschaltverhalten erreicht werden. Durch ein Kurzschließen der Steuerkontakte der Feldeffekttransistoren mittels des Schaltelements kann ein besonders schneller Abbau einer zwischen den Steuerkontakten anliegenden, den Feldeffekttransistor aktivierenden Spannung bewirkt werden. Weiterhin kann die Aktivierung und Deaktivierung des Feldeffekttransistors durch preiswerte Mittel erreicht werden.

Vorteilhaft sind die zumindest zwei Feldeffekttransistoren als MOSFETs ausgebildet. Es kann insbesondere eine effiziente und/oder preiswerte Ausgestaltung erreicht werden. Weiterhin wird vorgeschlagen dass der Treiberschaltkreis zumindest eine Zener-Diode aufweist, die zwischen den Steuerkontakten des Schaltelements angeordnet ist. Insbesondere weist die Zener-Diode eine Durchbruchsspannung, insbesondere zumindest 3 V, vorteilhaft zumindest 10 V, vorzugsweise zumindest 15 V, vorteilhaft maximal 25 V auf, die maximal einem Wert entspricht, der der Ansteuerspannung der Vorrichtung entspricht. Vorzugsweise entspricht einer Durchbruchsspannung der Zener-Diode zumindest einer Schaltspannung des Schaltelements. Insbesondere stellt die Zener-Diode bei einer Deaktivierung der Schaltkomponente ein elektrisches Signal bereit, das das Schaltelement aktiviert. Insbesondere wird die Zener-Diode bei einer Deaktivierung der Schaltkomponente in Sperrrichtung von Ladung durchflossen, die auf einem Steuerkontakt des Feldeffekttransistors gespeichert ist und erzeugt einen Spannungsabfall über den Steuerkontakten des Schaltelements. Insbesondere ist die Zener-Diode derart angeordnet, dass Sie bei einem Einschalten des zugeordneten Feldeffekttransistors in Durchflussrichtung von Ladungsträgern durchströmt wird. Es kann insbesondere eine hohe Zuverlässigkeit erreicht werden. Insbesondere kann eine ausreichende, genau bestimmte und/oder anhaltende Schaltspannung für das Schaltelement bereitgestellt werden. Weiterhin wird vorgeschlagen, dass der Treiberschaltkreis zumindest eine Schutzdiode aufweist, die einen, insbesondere von Leistungskontakten der Schaltkomponente ausgehenden, Spannungsabfall über dem zugeordneten Feldeffekttransistor und/oder dem Schaltelement in einem Ausschaltzustand zumindest eines der Feldeffekttransistoren reduziert. Insbesondere weist die Schutzdiode eine Sperrspannung auf, die zumindest im Wesentlichen einer Sperrspannung der Schaltkomponente, insbesondere zumindest 300 V, vorteilhaft zumindest 450 V, vorzugsweise zumindest 600 V, entspricht. Insbesondere bildet ein Kontakt der Schutzdiode einen Signaleingang des Treiberschaltkreises. Vorteilhaft sind die Schutzdiode und die Zener-Diode in Reihe, vorzugsweise in gleiche Richtung gleichrichtend, geschaltet, wobei die Zenerdiode vorzugsweise zwischen der Schutzdiode und dem Feldeffekttransistor angeordnet ist. Vorzugsweise ist eine Anode der einen Diode unmittelbar mit einer Kathode der anderen Diode verbunden. Vorteilhaft weist der Treiberschaltkreis eine Trennkapazität, insbesondere in Form eines einzelnen Kondensators, auf, die parallel zu der Schutzdiode angeordnet ist. Insbesondere weist die Trennkapazität eine Impedanz gegen Spannung auf, die zumindest der Sperrimpedanz der Schutzdiode entspricht. Insbesondere kann erreicht werden, dass die Zener-Diode bei einem Einschalten der Schaltkomponente vor der Schutzdiode leitend wird, was insbesondere einen schnellen Einschaltvorgang ermöglicht. Insbesondere weist die Trennkapazität eine Kapazität auf, die einem 0,001-fachen bis 100-fachen einer Parasitärkapazität der Zenerdiode entspricht. Insbesondere weist die Trennkapazität einen Wert zwischen 10 pF und 10 nF auf.

Ferner ist erfindungsgemäß vorgesehen, dass die Schaltkomponente zumindest einen Haupttreiber aufweist, der in zumindest einem Betriebszustand jeden der Treiberschaltkreise zumindest mit einem elektrischen Signal, insbesondere zumindest mit einer Spannung, insbesondere mit einer Spannung größer 0 V, insbesondere größer 1 V, vorteilhaft größer 10 V, vorzugsweise größer 15 V, und insbesondere kleiner 25 V, vorteilhaft kleiner 20 V, beaufschlagt.

Erfindungsgemäß sind Eingangskontakte der Treiberschaltkreise miteinander verbunden und gleichzeitig direkt an einen Ausgangskontakt des Haupttreibers angeschlossen. Insbesondere weist der Haupttreiber zumindest einen Ansteuerschritt (DRIVER) auf, der ein Steuersignal, das insbesondere von einer Steuereinheit gesendet wird, in einen Ausgangswert umsetzt, so dass ein Potential am Ausgangskontakt des Haupttreibers mehr als 0 V, insbesondere mehr als 1 V, vorteilhaft mehr als 5 V, vorzugsweise mehr als 15 V, und insbesondere weniger als 25 V, vorteilhaft weniger als 20 V, von einem Potential an einem der Leistungskontakte, insbesondere dem Leistungskontakt der Schaltkomponente, der direkt mit einem Steuerkontakt eines der Feldeffekttransistoren verbunden ist, abweicht, vorzugsweise größer ist als das Potential dieses Leistungskontakts.

Vorteilhaft wird vorgeschlagen, dass die Elemente des Treiberschaltkreises und/oder die Feldeffekttransistoren als separate Bauteile ausgebildet sind. Durch eine Ausbildung der Feldeffekttransistoren als separate Bauteile kann insbesondere ein niedriger Kühlaufwand erreicht werden, auch wenn hohe Ströme geschaltet werden. Insbesondere weist eine Kühlanordnung des Schaltmoduls einen Wärmewiederstand von zumindest 10 K/W, insbesondere zumindest 20 K/W, vorteilhaft zumindest 50 K/W, vorzugsweise zumindest 80 K/W, auf. Insbesondere ist die Kühlanordnung von den Feldeffekttransistoren, bzw. ihren Bauteilgehäusen, an sich gebildet. Insbesondere kann auf einen zusätzlichen Kühlkörper und/oder einen Lüfter verzichtet werden, wodurch Bauraum, insbesondere Bauhöhe, gespart werden kann. Weiterhin kann eine Kostenersparnis erreicht werden. Insbesondere ist auch der zumindest eine Treiberschaltkreis aus einzelnen Bauteilen gebildet, die in geeigneter Weise auf einer Elektronikplatine angeordnet sind. Alternativ ist es denkbar, dass zumindest der eine Treiberschaltkreis als integriertes Bauteil ausgebildet ist. Da der Treiberschaltkreis an sich keine Wärmeverluste aufweist kann auf diese Weise eine hohe Platzersparnis erreicht werden. In einer weiteren Ausgestaltung ist es ebenfalls denkbar, dass die Feldeffekttransistoren und insbesondere auch die Treiberschaltkreise einen einzelnen integrierten Schaltkreis bilden, wodurch zwar die guten Kühlungseigenschaften, die durch separate Bauteile erreicht werden können, verloren gehen können, jedoch eine Platzersparnis möglich ist.

Besonders vorteilhaft findet die Erfindung Anwendung in einem Hausgerät mit einer Hausgerätevorrichtung, insbesondere einer Kochfeldvorrichtung und erfindungsgemäß in einer Induktionskochfeldvorrichtung, alternativ in einer Backofenvorrichtung, insbesondere einer Induktionsbackofenvorrichtung, die zumindest eine erfindungsgemäße Schaltkomponente aufweist. Es kann insbesondere eine Bauweise mit geringem Elektronikplatzbedarf erreicht werden. Vorzugsweise ist die Schaltkomponente Bestandteil eines Wechselrichters, vorteilhaft eines Induktionsheizkreises, wodurch insbesondere elektrisch effiziente Ausgestaltungen erreicht werden können. Insbesondere kann eine erfindungsgemäße Ausgestaltung eines Induktionsheizschaltkreises einen Betrieb mit Frequenzen deutlich über 100 kHz, bei akzeptablen Verlustleistungen, ermöglichen. Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen in schematischer Darstellung:
- Fig. 1: ein erfindungsgemäßes Kochfeld in einer Ansicht von oben,
- Fig. 2: ein Schaltbild einer erfindungsgemäßen Kochfeldvorrichtung,
- Fig. 3: ein erfindungsgemäßes Schaltelement,
- Fig. 4: ein Diagramm eines Betriebsablaufs der erfindungsgemäßen Kochfeldvorrichtung gemäß Figur 2 und
- Fig. 5: einen Effektivitätsvergleich einer erfindungsgemäßen Kochfeldvorrichtung mit einer äquivalenten Ausgestaltung mit IGBTs.

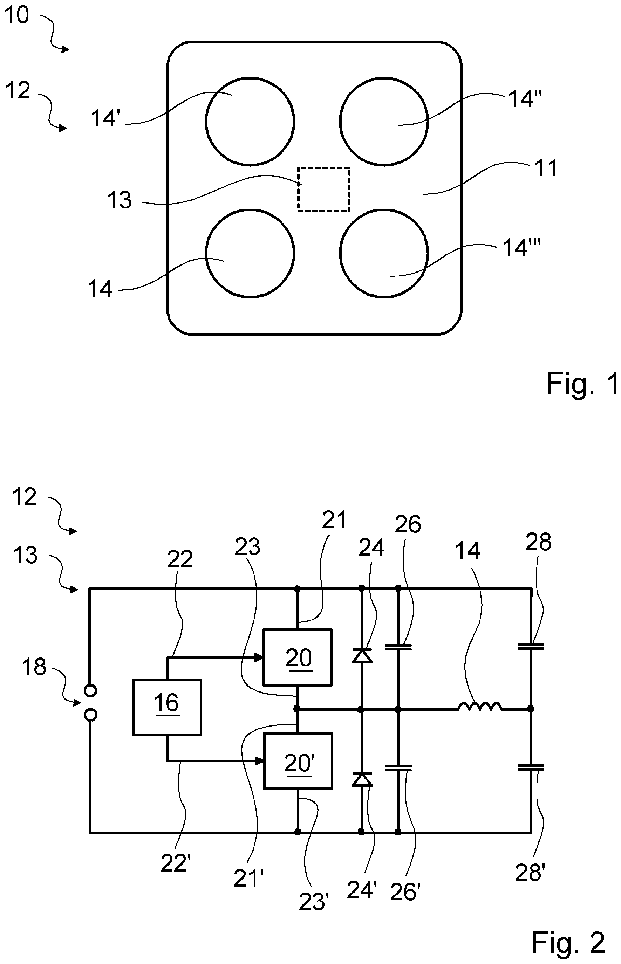

Figur 1 zeigt ein als Induktionskochfeld ausgebildetes Hausgerät 10 mit einer als Induktionskochfeldvorrichtung ausgebildeten Hausgerätevorrichtung 12. Die Hausgerätevorrichtung 12 weist vier Heizelemente 14, 14', 14", 14''' auf. Die Heizelemente 14, 14', 14", 14''' sind als Induktoren ausgebildet. Die Heizelemente 14, 14', 14", 14''' sind unter einer Kochfeldplatte 11 der Hausgerätevorrichtung 12 angeordnet. Weiterhin weist die Hausgerätevorrichtung 12 als Induktionsheizkreise ausgebildete Versorgungsschaltkreise 13 auf, um die Heizelemente 14, 14', 14", 14''' zu versorgen.

Figur 2 zeigt die Hausgerätevorrichtung 12 am Beispiel des Heizelements 14, das in einem Betriebszustand von dem Versorgungsschaltkreis 13 versorgt wird. Die übrigen Heizelemente 14', 14", 14''' sind in vergleichbaren Versorgungsschaltkreisen 13 angeordnet. Der Versorgungsschaltkreis 13 weist eine Energieversorgung 18 auf. Die Energieversorgung 18 weist eine Gleichrichtereinheit und eine Pufferkapazität auf.

Weiterhin weist die Energieversorgung 18 eine Filtereinheit auf. Der Versorgungsschaltkreis 13 weist zwei erfindungsgemäße Schaltkomponenten 20, 20' auf. Die Schaltkomponenten 20, 20' sind als Hausgeräteschaltkomponente, genauer als Kochfeldschaltkomponenten, ausgebildet. Der Versorgungsschaltkreis 13 weist eine halbbrückenartige Schaltung auf, wobei das Heizelement 14 in einem Brückenzweig angeordnet ist. Die zwei Schaltkomponenten 20, 20' sind zwischen Polen der Energieversorgung 18 in Reihe geschaltet. Ein erster Leistungskontakt 21 der ersten Schaltkomponente 20 ist mit einem positiven Pol der Energieversorgung 18 verbunden. Ein zweiter Leistungskontakt 23 der ersten Schaltkomponente 20 ist mit einem ersten Leistungskontakt 21' der zweiten Schaltkomponente 20' verbunden und bildet einen Mittelabgriff. Ein zweiter Leistungskontakt 23' der zweiten Schaltkomponente 20' ist mit einem negativen Pol der Energieversorgung 18 verbunden. An dem Mittelabgriff zwischen den Schaltkomponenten 20, 20' ist ein erster Kontakt des Heizelements 14 angeschlossen. Parallel zu den Schaltkomponenten 20, 20' ist jeweils eine Freilaufdiode 24, 24' geschaltet, wobei die Freilaufdiode 24, 24' mit ihrer Kathode an den positiven Pol der Energieversorgung 18 bzw. mit ihrer Anode an den negativen Pol der Energieversorgung 18 angeschlossen ist.

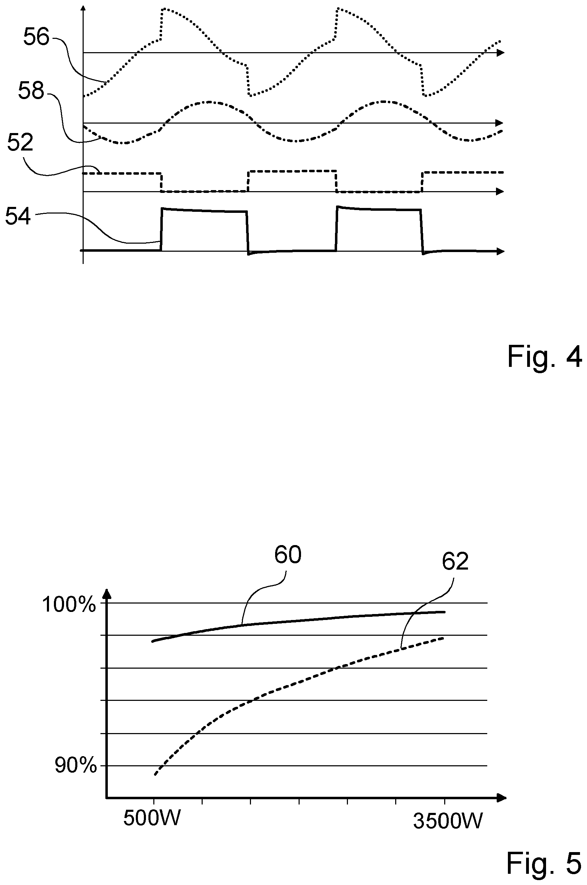

Weiterhin weist der Versorgungschaltkreis jeweils eine Snubberkapazität 26, 26' auf, die parallel zu den Schaltkomponenten 20, 20' geschaltet sind. Ferner weist der Versorgungsschaltkreis 13 eine Resonanzeinheit auf, an die ein zweiter Kontakt des Heizelements 14 angeschlossen ist. Die Resonanzeinheit ist von zwei Resonanzkapazitäten 28, 28' gebildet, die in Reihe zwischen die Pole der Energieversorgung 18 geschaltet sind. Ein Mittelabgriff zwischen den Resonanzkapazitäten 28, 28' ist an den zweiten Kontakt des Heizelements 14 angeschlossen. Alternativ ist es denkbar, dass die Resonanzeinheit lediglich eine Resonanzkapazität 28, 28' aufweist, die zwischen dem zweiten Kontakt des Heizelements 14 und einem der Pole der Energieversorgung 18 angeschlossen ist. Weiterhin weist der Versorgungsschaltkreis 13 eine Steuereinheit 16 auf, die dazu vorgesehen ist, in diversen Betriebsmodi die Schaltkomponenten 20, 20' über Ansteuerleitungen 22, 22' anzusteuern. Die Steuereinheit 16 ist dazu vorgesehen, die Schaltkomponenten 20, 20' abwechselnd anzusteuern, um über dem Mittelabgriff eine hochfrequente Wechselspannung mit einer Frequenz zwischen 20 kHz und 500 kHz zu erzeugen. Die Steuereinheit 16 erzeugt Steuersignale 52, die in der Schaltkomponente 20 in eine Spannung von 0 V oder 16 V umgewandelt werden (Figur 4). Entsprechend den Steuersignalen 52 sperrt die Schaltkomponente 20 eine zwischen ihren Leistungskontakten 21, 23 anliegende Spannung 54 bei inaktivem Steuersignal 52 oder stellt eine leitende Verbindung zwischen den Leistungskontakte 21, 23 her. Durch eine abwechselnde Aktivierung der Schaltkomponenten 20, 20' werden über dem Heizelement 14 ein periodischer Spannungsverlauf 56 und ein periodischer Stromverlauf 58 erreicht.

Weiterhin sind Ausgestaltungen denkbar, in denen eine Ein-Schaltertopologie zur Versorgung des Heizelements 14 eingesetzt ist, die lediglich eine einzelne erfindungsgemäße Schaltkomponente 20, 20' aufweist. Weiterhin sind Ausgestaltungen denkbar, in denen eine vollbrückenartige Topologie mit vier erfindungsgemäßen Schaltkomponenten zur Versorgung des Heizelements 14 eingesetzt ist. Es sind weitere Versorgungsschaltkreise denkbar, die vorzugsweise zur Versorgung eines Heizelements dienen und zumindest eine erfindungsgemäße Schaltkomponente aufweisen.

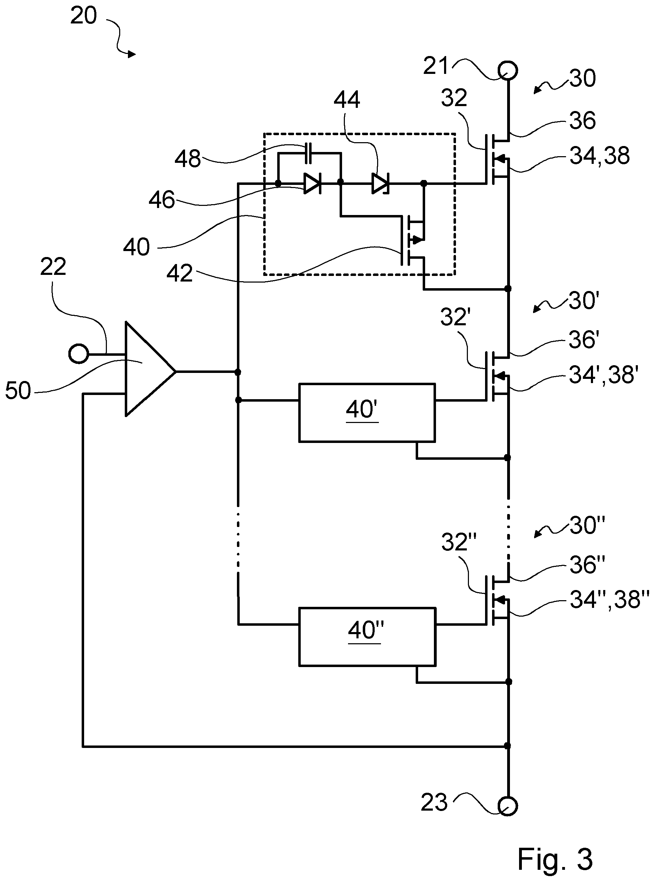

Figur 3 zeigt die Schaltkomponente 20. Die Schaltkomponente 20 weist eine Reihenschaltung von 16 Feldeffekttransistoren 30, 30', 30" auf. Die Feldeffekttransistoren 30, 30', 30" sind als MOSFETs ausgebildet. Die Feldeffekttransistoren 30, 30', 30" weisen jeweils eine Spannungsfestigkeit von 30 V auf. Für die Schaltkomponente 20 ergibt sich so eine Spannungsfestigkeit von 480 V. Weiterhin weist die Schaltkomponente 20 für jeden der Feldeffekttransistoren 30, 30', 30" einen Treiberschaltkreis 40, 40', 40", der dem entsprechenden Feldeffekttransistor 30, 30', 30" zugeordnet ist, auf. Die Feldeffekttransistoren 30, 30', 30" weisen jeweils zwei Leistungskontakte 36, 36', 36", 38, 38', 38" und zwei Steuerkontakte 32, 32', 32", 34, 34', 34" auf. Die Feldeffekttransistoren 30, 30', 30" weisen jeweils negative Majoritätsladungsträger auf. Ein erster Leistungskontakt 36 eines ersten der Feldeffekttransistoren 30 bildet einen ersten Leistungskontakt 21 der Schaltkomponente 20. Ein zweiter Leistungskontakt 38" eines letzten der Feldeffekttransistoren 30" bildet einen zweiten Leistungskontakt 23 der Schaltkomponente 20. Die ersten Leistungskontakte 36' der weiteren Feldeffekttransistoren 30' sind jeweils mit einem zweiten Leistungskontakt 38, 38' eines direkt vorhergehenden Feldeffekttransistors 30, 30' verbunden. Die zweiten Leistungskontakte 38' der weiteren Feldeffekttransistoren 30' sind jeweils mit einem ersten Leistungskontakt 36', 36" eines direkt nachfolgenden Feldeffekttransistors 30', 30" verbunden. Ein zweiter der Steuerkontakte 34, 34', 34" und ein zweiter der Leistungskontakte 38, 38', 38" der Feldeffekttransistoren 30, 30', 30" sind jeweils unmittelbar verbunden, so dass die Feldeffekttransistoren 30, 30', 30" technisch lediglich drei Kontakte aufweisen.

Am Beispiel des Treiberschaltkreises 40 sollen die gleich aufgebauten Treiberschaltkreise 40, 40', 40" nachfolgenden erläutert werden. Der Treiberschaltkreis 40 weist ein Schaltelement 42 auf, das zumindest bei einem Ausschaltvorgang die zwei Steuerkontakte 32, 34 des entsprechenden Feldeffekttransistors 30 kurzschließt. Ein erster Leistungskontakt des Schaltelements 42 ist direkt mit dem ersten Steuerkontakt 32 des Feldeffekttransistors 30 verbunden. Ein zweiter Leistungskontakt des Schaltelements 42 ist direkt mit dem zweiten Steuerkontakt 34 des Feldeffekttransistors 30 verbunden. Somit ist der zweite Steuerkontakt des Schaltelements 42 ebenfalls mit dem zweiten Leistungskontakt 38 des Feldeffekttransistors 30 verbunden. Das Schaltelement 42 ist als Feldeffekttransistor und insbesondere als MOSFET ausgebildet. Das Schaltelement 42 weist positive Majoritätsladungsträger auf. Ein erster Leistungskontakt des Schaltelements 42 ist unmittelbar mit dem zweiten Steuerkontakt des Schaltelements 42 verbunden. Das Schaltelement 42 weist eine Spannungsfestigkeit von 20 V auf.

Weiterhin weist der Treiberschaltkreis 40 eine Zener-Diode 44 auf, die zwischen Steuerkontakten des Schaltelements 42 angeordnet ist. Die Zener-Diode 44 ist direkt mit dem ersten Steuerkontakt 32 des Feldeffekttransistors 30 verbunden. Die Zener-Diode 44 weist eine Durchbruchsspannung von 10 V auf. Die Zener-Diode 44 ist mit ihrer Kathode direkt mit dem ersten Steuerkontakt 32 des Feldeffekttransistors 30 verbunden.

Weiterhin weist der Treiberschaltkreis 40 eine Schutzdiode 46 auf. Die Schutzdiode 46 weist eine Spannungsfestigkeit von 500 V auf. Die Schutzdiode 46 vermeidet durch ihre hohe Spannungsfestigkeit einen Durchbruch des Feldeffekttransistors 30 über den Treiberschaltkreis 40. Ein Spannungsabfall über dem zugeordneten Feldeffekttransistor 30 wird in einem Ausschaltzustand der Schaltkomponente 20, also bei inaktivem Steuersignal 52, reduziert. Die Schutzdiode 46 und die Zener-Diode 44 sind in Reihe geschaltet. Eine Kathode der Schutzdiode 46 ist direkt mit einer Anode der Zener-Diode 44 verbunden. Der erste Steuerkontakt des Schaltelements 42 ist sowohl mit der Zener-Diode 44 als auch mit der Schutzdiode 46 verbunden. Der erste Steuerkontakt des Schaltelements 42 ist direkt mit der Anode der Zener-Diode und mit der Kathode der Schutzdiode 46 verbunden. Der zweite Steuerkontakt des Schaltelements 42 ist direkt mit der Kathode der Zener-Diode 44 verbunden.

Ferner weist der Treiberschaltkreis 40 eine Trennkapazität 48 auf, die parallel zu der Schutzdiode 46 geschaltet ist. Ein von der Zener-Diode 44 abgewandter Kontakt der Schutzdiode 46 bildet einen Signaleingang des Treiberschaltkreises 40. Spannungsänderungen am Signaleingang werden über die Trennkapazität 48 als Spannungspulse in den Treiberschaltkreis 40 eingeleitet.

Die Schaltkomponente 20 weist weiterhin einen Haupttreiber 50 auf, der bei Ansteuerung durch die Steuereinheit 16 über die Ansteuerleitung 22 die Treiberschaltkreise 40, 40', 40" mit elektrischen Signalen beaufschlagt. Die Signaleingänge der Treiberschaltkreise 40, 40', 40" sind direkt miteinander verbunden. Die Signaleingänge der Treiberschaltkreise 40, 40', 40" sind mit einem Ausgang des Haupttreibers 50 verbunden.

Der Haupttreiber 50 legt zwischen den Signaleingängen der Treiberschaltkreise 40, 40', 40" und dem zweiten Steuerkontakt 34, bzw. Leistungskontakt 38" des letzen der Feldeffekttransistoren 30", eine Schaltspannung an. Die Schaltspannung beträgt bei einem Einschaltvorgang ca. 16 V. Das Anlegen der Schaltspannung erzeugt durch die Trennkapazität 48 einen ersten Spannungs- und Stromimpuls. Die Zener-Diode 44 wird vor der Schutzdiode 46 leitend und überträgt Ladung auf den ersten Steuerkontakt 32 des zugeordneten Feldeffekttransistors 30. Der Feldeffekttransistor 30 wird dadurch leitend geschaltet. Effektiv werden die Feldeffekttransistoren 30, 30', 30" nacheinander, angefangen bei dem letzten Feldeffekttransistor 30" leitend geschaltet, so dass die Schaltkomponente 20 leitend wird. Eine Einschaltverzögerung zwischen den Feldeffekttransistoren 30, 30', 30" ist vernachlässigbar gegenüber einer Schaltfrequenz im Bereich bis einige Hundert MHz.

Bei einem Abschaltvorgang wird die Schaltspannung auf 0 V reduziert, wobei die Signaleingänge der Treiberschaltkreise 40, 40', 40" und der zweiten Leistungskontakt 38' des letzten Feldeffekttransistors 30" effektiv leitend miteinander verbunden werden. Dies erzeugt durch die Trennkapazität 48 einen zweiten Spannungs- und Stromimpuls. Der zweite Spannungs- und Stromimpuls zieht einen Teil der Ladung, die auf dem ersten Steuerkontakt 32 des Feldeffekttransistors 30 angeordnet ist, rückwärts über die Zener-Diode 44 ab. Dabei fällt über der Zener-Diode 44 eine Spannung ab, die insbesondere einige Zeit durch eine intrinsische Kapazität der Zener-Diode 44 aufrechterhalten wird. Die über der Zener-Diode 44 abfallende Spannung schaltet das Schaltelement 42 in einen leitenden Zustand, so dass eine Restladung zwischen den Steuerkontakten 32, 34 des Feldeffekttransistors 30 schnell abgebaut werden kann. Da der zweite Spannungs- und Ladungsimpuls auf alle Treiberschaltkreise 40, 40', 40" und somit Feldeffekttransistoren 30, 30', 30" gleichzeitig wirkt, kann auch, wenn einer der Feldeffekttransistoren 30, 30', 30" effektiv zeitiger trennt als andere der Feldeffekttransistoren 30, 30', 30" durch die Spannung der Zener-Diode 44, die das Schaltelement 42 leitend hält, ein sicheres Ausschalten bewirkt werden, was im Wesentlichen gleichzeitig für jeden der Feldeffekttransistoren 30, 30', 30" stattfindet.

Die Schaltkomponenten 20, 20' sind gleich aufgebaut. Alternativ ist es denkbar, dass zumindest eine der Schaltkomponenten 20, 20' auf Feldeffekttransistoren aufgebaut ist, die positive Majoritätsladungsträger aufweisen, wobei weitere Elemente und interne Verdrahtung äquivalent angepasst sind. Weiterhin ist es denkbar, dass bei dem letzten der Feldeffekttransistoren 30" auf einen Treiberschaltkreis 40" verzichtet wird. Ferner ist es denkbar, dass der Haupttreiber 50 der Schaltkomponente 20 in die Steuereinheit 16 integriert ist.

Weiterhin sind die Elemente der Treiberschaltkreise 40, 40', 40" und die Feldeffekttransistoren 30. 30', 30" als separate Bauteile ausgebildet. Die Feldeffekttransistoren 30. 30', 30" und die Bauteile der Treiberschaltkreise 40, 40', 40" sind einzeln nebeneinander auf einer Elektronikplatine angeordnet und entsprechend über diese leitend miteinander verbunden. Je nach Wahl der Bauelemente kann eine Bauhöhe der bestückten Platine erreicht werden, die geringer ist als 1 cm oder gar geringer ist als 0,5 cm. Durch die verteilte Anordnung der Bauelemente genügt eine Luftkühlung über einfache Lüftungsschlitze, wobei auf einen Lüfter verzichtet werden kann, was wiederum eine Geräuschreduzierung bewirken kann. Im Wesentlichen kann bei Verwendung separater Bauteile zur Konstruktion der Schaltkomponenten 20, 20', vor allem der Verwendung einzelner Feldeffekttransistoren, eine kostenmäßig vergleichsweise oder gar preiswertere Ausgestaltung erreicht werden. Eine möglicherweise gegenüber einer herkömmlichen Lösung mit IGBTs vergrößerte, benötigte Platinenfläche kann im Wesentlichen durch einen Wegfall von für eine Lüfter- und Kühlereinheit benötigter Fläche kompensiert werden. Um eine aufwendige Kühlung eines Gleichrichterblocks der Energieversorgung 18 zu vermeiden, wird weiterhin vorgeschlagen, auch diesen aus separaten Komponenten aufzubauen, anstatt aus einem einzelnen Kompaktbauteil. Alternativ ist es denkbar, eine erfindungsgemäße Schaltkomponente 20, 20' in einem als Wechselstrom-zu-Wechselstromgleichrichter ausgebildeten Versorgungsschaltkreis einzusetzen, wobei auf einen zu kühlenden Gleichrichterblock verzichtet werden kann.

Figur 5 zeigt einen Effizienzvergleich einer leistungsabhängigen Effizienz 60 eines mit erfindungsgemäßen Schaltkomponenten 20, 20' ausgestalteten Versorgungsschaltkreises 13 nach Figur 2, wobei eine Leistung des Heizelements 14 als Referenz genutzt ist, mit einer leistungsabhängigen Effizienz 62 eines mit herkömmlichen IGBTs ausgestatteten Versorgungschaltkreises analog Figur 2. Es kann gegenüber einer herkömmlichen Ausgestaltung mit IGBTs eine deutliche Effizienzsteigerung erreicht werden. Besonders bei niedrigen Leistungen des Heizelements 14, von beispielsweise 500 W, kann eine Effizienzsteigerung um 8 % erreicht werden. Bei hohen Leistungen des Heizelements 14 um 3000 W kann immerhin noch eine Effizienzsteigerung um ca. 2 % erreicht werden.

Mit steigender Anzahl an verwendeten Feldeffekttransistoren 30, 30', 30" je Schaltkomponente 20, 20' verringert sich ein effektiver Wiederstand der Schaltkomponente 20, 20' im leitenden Zustand. Ein Verhältnis des Wiederstands eines einzelnen der Feldeffekttransistoren 30, 30', 30" zum Wiederstand der Schaltkomponente 20, 20' entspricht der 1,6-ten Potenz der Anzahl der in Reihe geschalteten Feldeffekttransistoren 30, 30', 30".

### Bezugszeichen

- 10: Hausgerät
- 11: Kochfeldplatte
- 12: Hausgerätevorrichtung
- 13: Versorgungsschaltkreis
- 14: Heizelement
- 16: Steuereinheit
- 18: Energieversorgung
- 20: Schaltkomponente
- 21: Leistungskontakt
- 22: Ansteuerleitung
- 23: Leistungskontakt
- 24: Freilaufdiode
- 26: Snubberkapazität
- 28: Resonanzkapazität
- 30: Feldeffekttransistor
- 32: Steuerkontakt
- 34: Steuerkontakt
- 36: Leistungskontakt
- 38: Leistungskontakt
- 40: Treiberschaltkreis
- 42: Schaltelement
- 44: Diode
- 46: Schutzdiode
- 48: Trennkapazität
- 50: Haupttreiber
- 52: Steuersignal
- 54: Spannung
- 56: Spannungsverlauf
- 58: Stromverlauf
- 60: Effizienz
- 62: Effizienz

## Patentansprüche

1. Induktionskochfeldvorrichtung mit als Induktionsheizkreise ausgebildeten Versorgungsschaltkreisen, um Heizelemente zu versorgen und mit zumindest einer Schaltkomponente, insbesondere Hausgeräteschaltkomponente, die eine Reihenschaltung von zumindest zwei Feldeffekttransistoren (30, 30', 30"), und zumindest zwei Treiberschaltkreisen (40, 40', 40"), welche jeweils einem der zumindest zwei Feldeffekttransistoren (30, 30', 30") zugeordnet sind, aufweist und, die Bestandteil eines Induktionsheizkreises ist, wobei die Treiberschaltkreise (40, 40', 40") jeweils zumindest ein Schaltelement (42) aufweisen, das in zumindest einem Betriebszustand zwei Steuerkontakte (32, 34, 32', 34', 32", 34") des jeweiligen Feldeffekttransistors (30, 30', 30") kurzschließt, wobei die Schaltkomponente zumindest einen Haupttreiber (50) umfasst, der in zumindest einem Betriebszustand zumindest die zumindest zwei Treiberschaltkreise (40, 40', 40") zumindest mit einem elektrischen Signal beaufschlagt, wobei Eingangskontakte der Treiberschaltkreise (40, 40', 40") miteinander verbunden und gleichzeitig direkt an einen Ausgangskontakt des Haupttreibers (50) angeschlossen sind.

2. Induktionskochfeldvorrichtung nach Anspruch 1, **dadurch gekennzeichnet, dass** die zumindest zwei Feldeffekttransistoren (30, 30', 30") als MOSFETs ausgebildet sind.

3. Induktionskochfeldvorrichtung nach einem der vorhergehenden Ansprüche, **dadurch gekennzeichnet, dass** jeder der Treiberschaltkreis (40, 40', 40") zumindest eine Zener-Diode (44) aufweist, die zwischen den Steuerkontakten des Schaltelements (42) angeordnet ist.

4. Induktionskochfeldvorrichtung nach einem der vorhergehenden Ansprüche, **dadurch gekennzeichnet, dass** jeder Treiberschaltkreis (40, 40', 40") zumindest eine Schutzdiode (46) aufweist, die einen Spannungsabfall über dem zugeordneten Feldeffekttransistor (30, 30', 30") in einem Ausschaltzustand zumindest eines der Feldeffekttransistoren (30, 30', 30") reduziert.

5. Induktionskochfeldvorrichtung nach Anspruch 3 und Anspruch 4, **dadurch gekennzeichnet, dass** die Schutzdiode (46) und die Zener-Diode (44) in Reihe geschaltet sind.

6. Induktionskochfeldvorrichtung zumindest nach Anspruch 4, **dadurch gekennzeichnet, dass** jeder Treiberschaltkreis (40, 40', 40") zumindest eine Trennkapazität (48) aufweist, die parallel zu der Schutzdiode (46) angeordnet ist.

7. Induktionskochfeldvorrichtung nach einem der vorhergehenden Ansprüche, **dadurch gekennzeichnet, dass** die Elemente eines jeden Treiberschaltkreises (40, 40', 40") und die Feldeffekttransistoren (30, 30', 30") als separate Bauteile ausgebildet sind.

8. Hausgerät, insbesondere Kochfeld, mit zumindest einer Induktionskochfeldvorrichtung (12) nach einem der Ansprüche 1 bis 7.

## Claims

1. Induction hob apparatus with supply circuits configured as induction heating circuits, in order to supply heating elements and with at least one switching component, in particular a domestic appliance switching component, which has a series circuit of at least two field effect transistors (30, 30', 30") and at least two driver circuits (40, 40', 40"), which are each associated with one of the at least two field effect transistors (30, 30', 30"), and which is a component of an induction heating circuit, wherein the driver circuits (40, 40', 40") each have at least one switching element (42), which short circuits two control contacts (32, 34, 32', 34', 32", 34") of each field effect transistor (30, 30', 30") in at least one operating state, wherein the switching component comprises at least one main driver (50), which applies at least one electrical signal to at least the at least two driver circuits (40, 40', 40") in at least one operating state, wherein input contacts of the driver circuits (40, 40', 40") are connected to one another, being at the same time connected directly to an output contact of the main driver (50).

2. Induction hob apparatus according to claim 1, **characterised in that** the at least two field effect transistors (30, 30', 30") are configured as MOSFETs.

3. Induction hob apparatus according to one of the preceding claims, **characterised in that** each driver circuit (40, 40', 40") has at least one Zener diode (44), which is arranged between the control contacts of the switching element (42).

4. Induction hob apparatus according to one of the preceding claims, **characterised in that** each driver circuit (40, 40', 40") has at least one protective diode (46), which reduces a voltage drop across the assigned field effect transistor (30, 30', 30") when at least one of the field effect transistors (30, 30', 30") is switched off.

5. Induction hob apparatus according to claim 3 and claim 4, **characterised in that** the protective diode (46) and the Zener diode (44) are connected in series.

6. Induction hob apparatus at least according to claim 4, **characterised in that** each driver circuit (40, 40', 40") has at least one isolation capacitance (48), which is arranged parallel to the protective diode (46).

7. Induction hob apparatus according to one of the preceding claims, **characterised in that** the elements of each driver circuit (40, 40', 40") and the field effect transistors (30, 30', 30") are configured as separate components.

8. Domestic appliance, in particular a hob, with at least one induction hob apparatus (12) according to one of claims 1 to 7.

## Revendications

1. Dispositif de table de cuisson à induction comprenant des circuits de commutation d'alimentation réalisés en tant que circuits de chauffage à induction afin d'alimenter des éléments chauffants, et comprenant au moins un composant de commutation, notamment un composant de commutation d'appareil ménager, qui comprend un circuit en série constitué d'au moins deux transistors à effet de champ (30, 30', 30") et au moins deux circuits d'excitation (40, 40', 40"), lesquels sont respectivement associés à l'un des au moins deux transistors à effet de champ (30, 30', 30"), et qui fait partie d'un circuit de chauffage à induction, dans lequel les circuits d'excitation (40, 40', 40") comprennent respectivement au moins un élément de commutation (42) qui, dans au moins un état de fonctionnement, court-circuite deux contacts de commande (32, 34, 32', 34', 32", 34") du transistor à effet de champ (30, 30', 30") respectif, dans lequel le composant de commutation comprend au moins un excitateur principal (50) qui, dans au moins un état de fonctionnement, alimente au moins les au moins deux circuits d'excitation (40, 40', 40") au moins avec un signal électrique, dans lequel les contacts d'entrée des circuits d'excitation (40, 40', 40") sont reliés entre eux et sont simultanément directement raccordés à un contact de sortie de l'excitateur principal (50).

2. Dispositif de table de cuisson à induction selon la revendication 1, **caractérisé en ce que** les au moins deux transistors à effet de champ (30, 30', 30") sont réalisés comme MOSFET.

3. Dispositif de table de cuisson à induction selon l'une quelconque des revendications précédentes, **caractérisé en ce que** chaque circuit d'excitation (40, 40', 40") comprend au moins une diode Zener (44) qui est disposée entre les contacts de commande de l'élément de commutation (42).

4. Dispositif de table de cuisson à induction selon l'une quelconque des revendications précédentes, **caractérisé en ce que** chaque circuit d'excitation (40, 40', 40") comprend au moins une diode de protection (46) qui réduit une chute de tension par l'intermédiaire du transistor à effet de champ (30, 30', 30") associé dans un état désactivé au moins de l'un des transistors à effet de champ (30, 30', 30").

5. Dispositif de table de cuisson à induction selon la revendication 3 et la revendication 4, **caractérisé en ce que** la diode de protection (46) et la diode Zener (44) sont commutées en série.

6. Dispositif de table de cuisson à induction au moins selon la revendication 4, **caractérisé en ce que** chaque circuit d'excitation (40, 40', 40") comprend au moins une capacité de coupure (48) qui est disposée parallèlement à la diode de protection (46).

7. Dispositif de table de cuisson à induction selon l'une quelconque des revendications précédentes, **caractérisé en ce que** les éléments de chaque circuit d'excitation (40, 40', 40") et les transistors à effet de champ (30, 30', 30") sont réalisés comme composants séparés.

8. Appareil ménager, notamment table de cuisson, comprenant au moins un dispositif de table de cuisson à induction (12) selon l'une quelconque des revendications 1 à 7.
